# EUROPÄISCHE PATENTANMELDUNG

(11) **EP 1 296 383 A2**
(43) Veröffentlichungstag der Anmeldung: **26.03.2003**
(21) Anmeldenummer: 02015876.2
(22) Anmeldetag: 16.07.2002
(51) Int. Cl.: H01L 33/00

(54) **Beleuchtungseinheit mit mindestens einer LED als Lichtquelle**

(30) Priorität: 20.09.2001 DE 10146719
(71) Anmelder: Patent-Treuhand-Gesellschaft für elektrische Glühlampen mbH, 81543 München (DE)
(72) Erfinder: Ellens, Andries, Dr., 2561 SL Den Haag (NL); Huber, Günter, 86529 Schrobenhausen (DE)

(57) **Zusammenfassung**

Beleuchtungseinheit mit mindestens einer LED als Lichtquelle, wobei die LED primäre Strahlung im Bereich 300 bis 430 nm emittiert, wobei diese Strahlung vollständig in längerwellige Strahlung konvertiert wird durch Leuchtstoffe, die der primären Strahlung der LED ausgesetzt sind, wobei die Konversion zumindest unter Zuhilfenahme eines Leuchtstoffs, der grün mit einer Wellenlänge der Peakemission bei 495 bis 540 nm emittiert und der aus der Klasse der Ce-aktivierten Sialone stammt, wobei das Sialon der Formel M_{p/2}Si_{12-p-q}Al_{p+q}O_{q}N_{16-q}:Ce³⁺ gehorcht, mit M = Ca einzeln oder in Kombination mit Sr, mit q = 0 bis 2,5 und p = 0,5 bis 3.

## Beschreibung

### Technisches Gebiet

Die Erfindung geht aus von einer Beleuchtungseinheit mit mindestens einer LED als Lichtquelle gemäß dem Oberbegriff des Anspruchs 1. Es handelt sich dabei insbesondere um eine im Sichtbaren oder Weiß emittierende LED auf Basis einer primär UV emittierenden LED.

### Stand der Technik

Eine Beleuchtungseinheit mit mindestens einer LED als Lichtquelle, die beispielsweise weißes Licht abgibt, wird derzeit vorwiegend durch die Kombination einer im Blauen bei etwa 460 nm emittierenden Ga(In)N-LED und eines gelb emittierenden YAG:Ce³⁺-Leuchtstoffs realisiert (US 5 998 925 und EP 862 794). Dabei werden für eine gute Farbwiedergabe oft zwei verschiedene Gelb-Leuchtstoffe verwendet wie in WO-A 01/08453 beschrieben. Problematisch dabei ist, dass die beiden Leuchtstoffe oft unterschiedliches Temperaturverhalten zeigen, auch wenn ihre Struktur ähnlich ist. Ein bekanntes Beispiel ist der im Gelben lumineszierende Ce-dotierte Y-Granat (YAG:Ce) und der im Vergleich dazu längerwellig lumineszierende (Y,Gd)-Granat. Dies führt zu Farbortschwankungen und Änderungen der Farbwiedergabe bei unterschiedlichen Betriebstemperaturen.

Aus der Veröffentlichung "On new rare-earth doped M-Si-Al-O-N materials" von van Krevel, TU Eindhoven 2000, ISBN 90-386-2711-4, Kapitel 11, ist eine Klasse von Leuchtstoffmaterialien bekannt, die in Abkürzung ihrer Struktur als Sialone 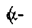 -Sialone) bezeichnet werden, die mit Ce, Eu, oder Tb dotiert sein können. Bei Dotierung mit Ce wird eine Emission im Bereich von 515 bis 540 nm erzielt bei Anregung mit 365 nm oder 254 nm.

### Darstellung der Erfindung

Es ist Aufgabe der vorliegenden Erfindung, eine Beleuchtungseinheit mit mindestens einer LED als Lichtquelle gemäß dem Oberbegriff des Anspruchs 1 bereitzustellen, die sich durch hohe Konstanz bei wechselnden Betriebstemperaturen auszeichnet. Eine weitere Aufgabe ist, eine Beleuchtungseinheit bereitzustellen, die weiß emittiert und insbesondere eine hohe Farbwiedergabe und hohe Ausbeute besitzt.

Diese Aufgabe wird durch die kennzeichnenden Merkmale des Anspruchs 1 gelöst. Besonders vorteilhafte Ausgestaltungen finden sich in den abhängigen Ansprüchen.

Erfindungsgemäß wird als Leuchtstoff für die LED-basierte Beleuchtungseinheit ein Sialon verwendet, das grün emittiert und aus der Klasse der Ce-aktivierten Sialone stammt, wobei das Sialon der Formel M_{p/2}Si_{12-p-q}Al_{p+q}O_{q}N_{16-q}:Ce³⁺ gehorcht, mit M = Ca einzeln oder in Kombination mitSr, mit q = 0 bis 2,5 und p = 1,5 bis 3. Bevorzugt wird ein hoher Wert für p gewählt, nämlich p = 2,5 bis 3, und ein relativ niedriger Wert für q, nämlich q = 0 bis 1, insbesondere bis 0,8. Bevorzugt wird Ca alleine für das Kation M verwendet.

Der Ce-Anteil, der einen Teil des Kations M ersetzt, sollte bei 0,5 bis 15 %, bevorzugt 1 bis 10 %, insbesondere 2 bis 6 %, des M-Kations liegen, wodurch eine besonders genaue Wahl der Emissionswellenlänge getroffen werden kann und auch die Lichtausbeute optimiert werden kann. Ein steigender Ce-Gehalt bewirkt im allgemeinen eine Verschiebung der Peakemission zu längeren Wellenlängen hin.

Besondere Vorteile dieses Leuchtstoffs in Verbindung mit einer LED-basierten Beleuchtungseinheit sind seine hohe Effizienz, seine überragende Temperaturstabilität (keine Empfindlichkeit gegen Änderungen der Betriebstemperatur) und eine überraschend hohe Löschtemperatur der Lumineszenz sowie die damit erzielbare hohe Farbwiedergabe, insbesondere bei Kombination mit mindestens einem weiteren Leuchtstoff. Die Löschtemperatur, also die Temperatur, bei der die Lumineszenz aufgrund der zugeführten Wärme zerstört wird, ist sogar so hoch, dass sie außerhalb des vorgewählten Messbereichs (maximal 140 °C) lag.

Ein weiterer Vorteil dieser Leuchtstoffklasse ist, dass bereits das Ausgangsmaterial (insbesondere Si₃N₄) in feinstdisperser Form vorliegt. Dieser Leuchtstoff muss daher nicht mehr gemahlen werden, wodurch ein Arbeitsgang gespart wird und keine Effizienzverluste auftreten. Typische mittlere Korngrößen des Leuchtstoffs liegen bei 0,5 bis 5 µm. Dagegen müssen konventionelle Leuchtstoffe wie YAG:Ce gemahlen werden, damit sie im Gießharz dispergiert bleiben und nicht auf den Boden absinken. Dieser Mahlvorgang führt häufig zu Effizienzverlusten. Der erfindungsgemäße Leuchtstoff hat trotz feiner Korngröße des Ausgangsmaterials eine gute Absorption.

Neben der Erzeugung einer farbigen Lichtquelle durch Anregung mittels UV-Strahlung einer LED bietet vor allem die Erzeugung von weißem Licht mit Hilfe dieses Leuchtstoffs Vorteile. Dies geschieht bei einer UV-emittierenden LED als primäre Lichtquelle unter Verwendung mindestens dreier Leuchtstoffe.

Weißes Licht mit guter Farbwiedergabe wird insbesondere erzeugt durch die Kombination einer UV-LED (z.B. Primäremission bei 300 bis 430 nm, bevorzugt 380 bis 420 nm), eines erfindungsgemäßen Grünleuchtstoffs (Emission zwischen 495-540 nm) und eines blau (Emission: 440-480 nm) sowie eines rot emittierenden Leuchtstoffs (Emission: 560- 620 nm).

Als Grün-Leuchtstoff wird M_{p/2}Si_{12-p-q}Al_{p+q}O_{q}N_{16-q}:Ce³⁺ verwendet. Dabei ist M = Ca einzeln oder in Kombination mit Sr, bevorzugt liegt der Sr-Anteil bei weniger als 30 mol-%. Dieser grüne Leuchtstoff hat eine hervorragende Thermostabilität und zeigt ein ausgezeichnetes Lumineszenzverhalten bei höheren Temperaturen, wie sie für LEDs typisch sind: bis 80°C zeigt er im Rahmen der Messgenauigkeit keinen Rückgang der Lumineszenz. Im Vergleich dazu weisen die herkömmlichen Granatleuchtstoffe bei 80°C einen deutlich messbaren Rückgang der Lumineszenz auf: er kann 5 bis 30 % betragen, abhängig von der gewählten Kationenzusammensetzung im System (Y,Gd,Lu)₃(Al,Ga)₅O₁₂.

Die großen Vorteile von Ce-Sialonen sind ihre ausgeprägte Stabilität gegenüber heißen Säuren, Laugen und auch ihre thermische und mechanische Stabilität. Überraschenderweise zeigen diese Sialone exzellentes Temperatur-Löschverhalten der Lumineszenz von Aktivatorionen in diesen Verbindungen. Das macht diese Verbindungen zu starken Konkurrenten von Leuchtstoffen, die manchmal bei Raumtemperatur heller u/o effizienter leuchten, aber in der Anwendung Lumineszenzverlust durch Temperaturlöschung zeigen. Zum Beispiel hat das blaugrün leuchtende Sr₄Al₁₄O₂₅:Eu²⁺ eine Quanteneffizienz von etwa 85% bei Raumtemperatur. Bei 100°C aber ist die Effizienz auf etwa 60% gesunken. Thiogallate, dotiert mit Eu²⁺, abhängig von ihrer Kationzusammensetzung (MGa₂S₄:Eu²⁺) können im gesamten grünen Bereich lumineszieren, verlieren ebenfalls 20%-30%. Gelb lumineszierende Ce³⁺-dotierte Granate verlieren, abhängig vom Anteil Gd:Y und Al:Ga bei hoher Temperatur etwa 10-30% der Effizienz bei Raumtemperatur.

Eine Weißmischung kann erzeugt werden auf Basis einer UV-emittierenden LED mittels dieser Ce-dotierten Sialone zusammen mit einem Blauleuchtstoff, wie z.B. BaMgAl₁₀O₁₇:Eu²⁺ (BAM), Ba₅SiO₄(Cl,Br)₆:Eu²⁺, CaLa₂S₄:Ce³⁺ oder (Ca,Sr,Ba)₅(PO₄)₃Cl:Eu²⁺ (SCAP). Ein weiterer Bestandteil ist ein Rotleuchtstoff wie (Y,La,Gd,Lu)₂O₂S:Eu³⁺, SrS:Eu²⁺ oder Sr₂Si₅N₈:Eu²⁺.

Die Farbwiedergabe kann bei Bedarf noch verbessert werden durch Zugabe eines weiteren Grünleuchtstoffs mit verschobenem Emissionsmaximum (beispielsweise Eu-dotierte Thiogallate oder Sr-Aluminate). Eine weitere Möglichkeit ist der Einsatz des Ce-dotierten Sialons als einziger Leuchtstoff zum Erzielen einer farbig emittierenden LED.

Abhängig vom Ce³⁺-Gehalt ist die Körperfarbe dieses Materials, insbesondere bei geringem Sauerstoffgehalt, fast weiß über blassgrün bis tief grün. Wegen der hervorragenden Temperaturstabilität und auch mechanischen Stabilität ist dieses Ce-Sialon gut geeignet als umweltfreundliches grünes Pigment oder Leuchtstoff für verschiedenste Anwendungen. Dies gilt insbesondere dann, wenn M durch 5 bis 10 % Ce ersetzt ist.

Im allgemeinen ist die Quanteneffizienz umso höher, je kleiner q und je größer p gewählt ist. Besonders bevorzugt ist ein Leuchtstoff mit M=Ca, p=3 und q=0.

Das Licht, das der erfindungsgemäße Leuchtstoff unter UV-Licht emittiert, ist sehr ungesättigtes Grün, mit Farbkoordinaten von x ∼ 0.22 / y ∼ 0.41. Die Lumineszenz hängt aber von Ce³⁺-Gehalt ab: die Emission verschiebt sich langwellig bei steigendem Ce³⁺-Gehalt.

Überraschend sind die optischen Eigenschaften andersals die der in der Literatur beschriebenen Sialone, zumindest bei geringem Sauerstoffgehalt (unter 5 mol-% des Stickstoffanteils, bevorzugt unter 2 mol-%) und hohem Kationenanteil (p = 1,5 bis 3). Die Proben sind oft weiß bis grünlich-weiß, sie absorbieren deshalb nicht im blauen Bereich und lumineszieren deutlich kurzwelliger als in der Literatur beschrieben. Das bedeutet, dass der erfindungsgemäße Leuchtstoff sehr gut geeignet ist für die UV-LED (oder eventuell UV-Anwendungen), und dass er vor allem keine konkurrierende Absorption von blauem Licht zeigt, so dass eine relativ langwellige UV-Primäremission (380 bis 420 nm) gewählt werden kann. Je langwelliger die UV-Emission gewählt werden kann, desto energieärmer ist sie und desto mehr schont sie die LED, was die Lebensdauer verlängert. Dieses vorteilhafte Verhalten zeigen insbesondere Leuchtstoffe mit keinem oder geringem Sauerstoffanteil, also bis höchstens 5 mol-%, bezogen auf Stickstoff, entsprechend der Formel M_{p/2}Si_{12-p-q}Al_{p+q}O_{q}N_{16-q}:Ce³⁺, mit M = Ca einzeln oder in Kombination mit Sr, insbesondere mit q = 0 bis 0,7 und p = 2,5 bis 3.

### Figuren

Im folgenden soll die Erfindung anhand mehrerer Ausführungsbeispiele näher erläutert werden. Es zeigen:
- Figur 1: ein Halbleiterbauelement, das als Lichtquelle (LED) für weißes Licht dient;
- Figur 2: eine Beleuchtungseinheit mit Leuchtstoffen gemäß der vorliegenden Erfindung;
- Figur 3 bis 5: das Emissionsspektrum und Reflexionsspektrum von verschiedenen Sialon-Leuchtstoffen gemäß der vorliegenden Erfindung;
- Figur 6: das Temperaturverhalten von Sialon HU18A/01 sowie das Temperaturverhalten von Thiogallat-Leuchtstoff im Vergleich.

### Beschreibung der Zeichnungen

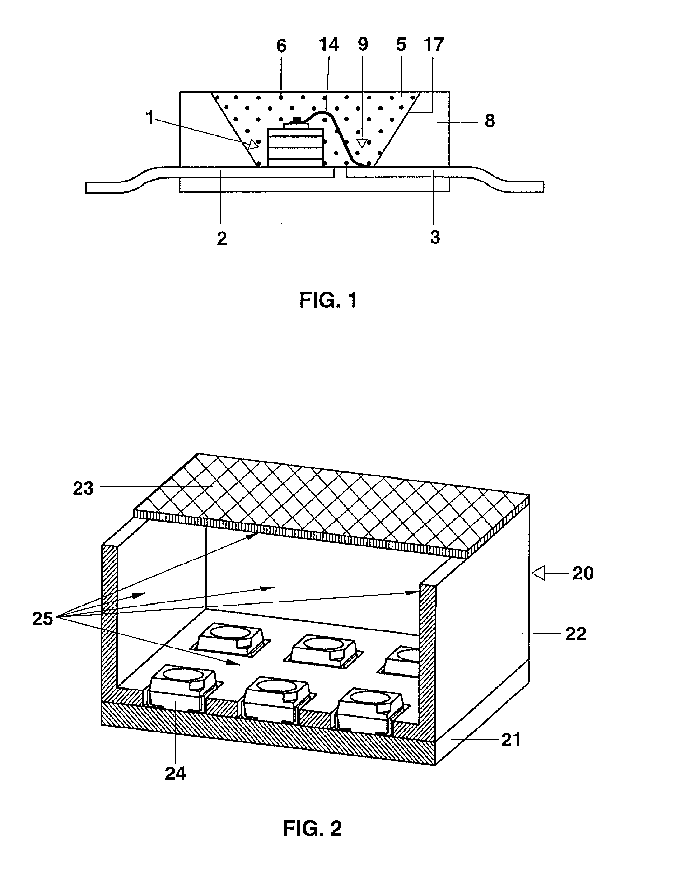

Für den Einsatz in einer weißen LED zusammen mit einem GaInN-Chip wird beispielsweise ein Aufbau ähnlich wie in US 5 998 925 beschrieben verwendet. Der Aufbau einer derartigen Lichtquelle für weißes Licht ist in Figur 1 explizit gezeigt. Die Lichtquelle ist ein Halbleiterbauelement (Chip 1) des Typs InGaN mit einer Peak-Emissionswellenlänge von 400 nm mit einem ersten und zweiten elektrischen Anschluss 2,3, das in ein lichtundurchlässiges Grundgehäuse 8 im Bereich einer Ausnehmung 9 eingebettet ist. Einer der Anschlüsse 3 ist über einen Bonddraht 14 mit dem Chip 1 verbunden. Die Ausnehmung hat eine Wand 17, die als Reflektor für die Primärstrahlung des Chips 1 dient. Die Ausnehmung 9 ist mit einer Vergussmasse 5 gefüllt, die als Hauptbestandteile ein Epoxidgießharz (80 bis 90 Gew.-%) und Leuchtstoffpigmente 6 (weniger als 15 Gew.-%) enthält. Weitere geringe Anteile entfallen u.a. auf Methylether und Aerosil. Die Leuchtstoffpigmente sind eine Mischung aus BAM, SrS und Sialon-Pigmenten.

In Figur 2 ist ein Ausschnitt aus einer Flächenleuchte 20 als Beleuchtungseinheit gezeigt. Sie besteht aus einem gemeinsamen Träger 21,auf den ein quaderförmiges äußeres Gehäuse 22 aufgeklebt ist. Seine Oberseite ist mit einer gemeinsamen Abdeckung 23 versehen. Das quaderförmige Gehäuse besitzt Aussparungen, in denen einzelne Halbleiter-Bauelemente 24 untergebracht sind. Sie sind UVemittierende Leuchtdioden mit einer Peakemission von typisch 360 nm. Die Umwandlung in weißes Licht erfolgt mittels Konversionsschichten, die direkt im Gießharz der einzelnen LED sitzen ähnlich wie in Figur 1 beschrieben oder Schichten 25, die auf allen der UV-Strahlung zugänglichen Flächen angebracht sind. Dazu zählen die innen liegenden Oberflächen der Seitenwände des Gehäuses, der Abdeckung und des Bodenteils. Die Konversionsschichten 25 bestehen aus drei Leuchtstoffen, die im roten, grünen und blauen Spektralbereich emittieren unter Benutzung der erfindungsgemäßen Leuchtstoffe.

Einige Leuchtstoffe des Sialon-Typs sind in Tab. 1 zusammengefasst. Es handelt sich um Ca-Sialone des Typs Ca_{1,5}Si₉Al₃N₁₆, wobei ein Anteil des Kations Ca, der zwischen 2 und 8 mol-% des Ca liegt, durch Ce ersetzt ist. Typische Quanteneffizienzen dieser Leuchtstoffe liegen bei 50 bis 70 %, wobei sich die Peakemission (max. Em.) von 497 nm bei geringer Ce-Dotierung zu etwa 508 nm bei hoher Ce-Dotierung verschiebt. Dieses Verhalten für sauerstofffreie Sialone ist besonders deswegen überraschend weil in der eingangs zitierten Literatur deutlich längerwellige Peakemissionen angegeben sind. Vermutlich hat hier der Sauerstoffanteil erhebliche Einwirkung. Erfindungsgemäß wird daher auch ein sauerstofffreies Pigment des Ce-Sialon-Typs beansprucht, das seine Peakemission im Bereich 495 bis 510 nm ausbildet.

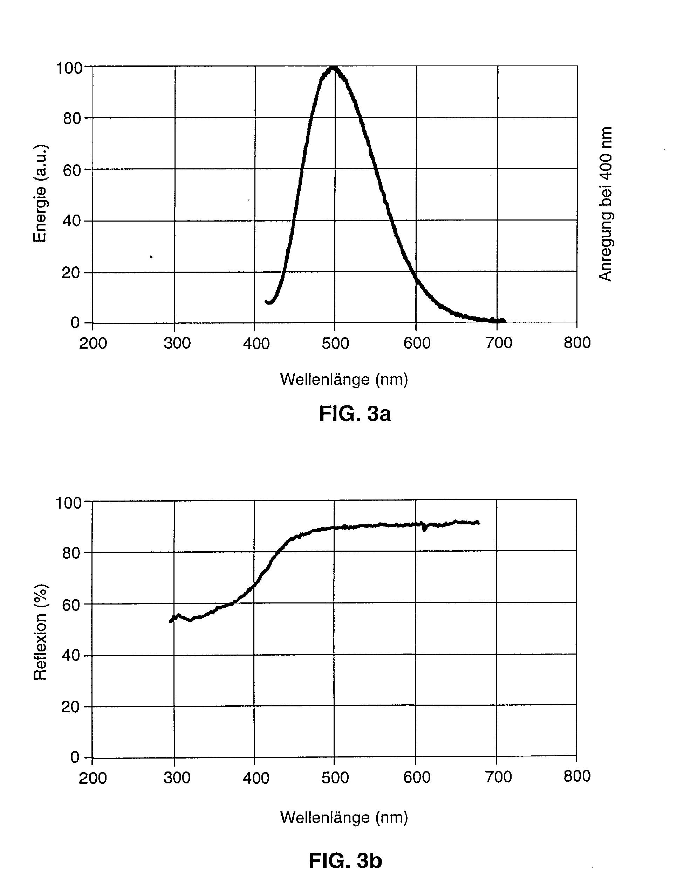

Fig. 3 bis 5 zeigt die Emission und das Reflexionsverhalten verschiedener Sialone als Funktion der Wellenlänge.

Im einzelnen zeigt Figur 3a das Emissionsspektrum des Sialons Ca_{1.5}Al₃Si₉N₁₆:Ce³⁺ (2,7 mol-% Anteil des Ce am Kation Ca ) (Versuchsnummer HU18A/01) bei Anregung durch 400 nm. Das Maximum liegt bei 499 nm, die mittlere Wellenlänge bei 517 nm. Die Quanteneffizienz QE spezieller Proben war 61 bis 71 %, abhängig von den Details der Präparation. Die Reflexion (Figur 3b) beträgt bei 400 nm etwa R400 = 66% und bei 360 nm etwa R360 = 57 %. Diese Daten sind auch in Tab. 1 aufgelistet.

Die Synthese des Sialons HU18A/01 wird im folgenden beispielhaft genauer beschrieben.

Das Leuchtstoffpulver wird durch eine Hochtemperatur-Festkörperreaktion hergestellt. Dazu werden beispielsweise die hochreinen Ausgangsmaterialien Ca₃N₂, AIN, und Si₃N₄ zusammengemischt mit einem Mol-Verhältnis von 1,44:3:9. Die Korngröße des Si₃N₄ liegt bei d₅₀ = 1,6 µm mit d₁₀ = 0,4 und d₉₀ = 3,9 µm. Eine kleine Menge CeO₂ (oder beispielsweise auch Ce-Nitrid) wird zum Zwecke der Dotierung hinzugefügt und ersetzt dabei die entsprechende Molmenge Ca₃N₂. Dies entspricht bei einem 2,7 mol-% Anteil des Ce der Bruttoformel (Ca_{1.46}Ce_{0,04})Al₃Si₉N₁₆. Aufgrund der Sauerstoffzugabe zusammen mit dem Ce als Ce-Oxid ist die exakte Bruttoformel als (Ca_{1.46}Ce_{0,04})Al₃Si₉O_{0,045}N_{15,97} anzusehen.

Nachdem die einzelnen Komponenten gut vermischt worden sind, wird das Pulver bei ca. 1700 °C für etwa 2 h in einer reduzierenden Atmosphäre (N₂/H₂) erhitzt und reagiert so zu der oben angegebenen Verbindung.

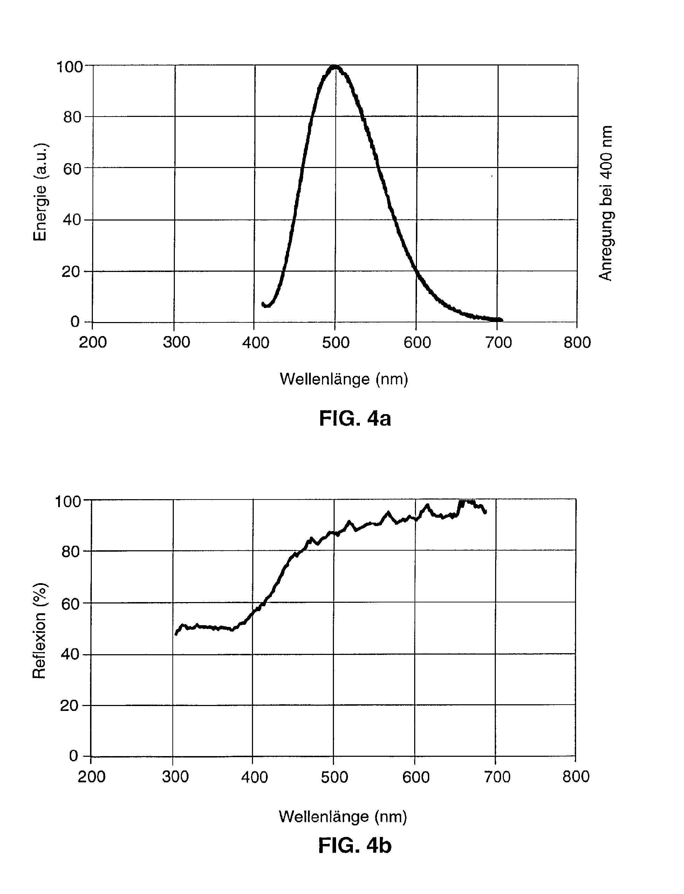

Figur 4 zeigt das Emissionsspektrum (Figur 4a) des Sialons Ca_{1.5}Al₃Si₉N₁₆:Ce³⁺ (5%) (Versuchsnummer HU31/01) bei Anregung durch 400 nm. Das Maximum liegt bei 498 nm, die mittlere Wellenlänge bei 520 nm. Die Quanteneffizienz QE ist 53%. Die Reflexion (Figur 4b) beträgt bei 400 nm etwa R400 = 55% und bei 360 nm etwa R360 = 48 %.

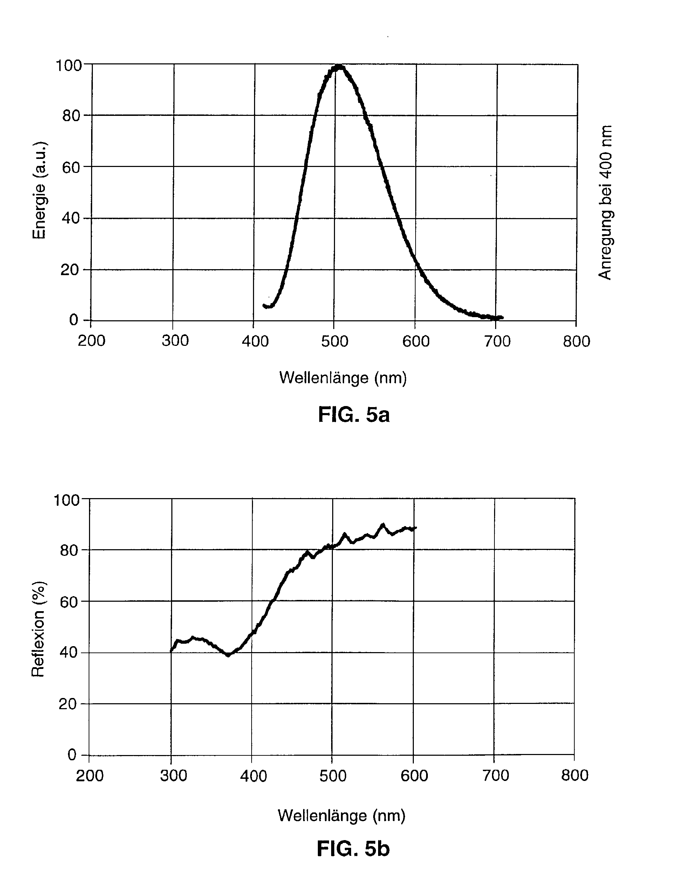

Figur 5 zeigt das Emissionsspektrum (Figur 5a) des Sialons Ca_{1.5}Al₃Si₉N₁₆:Ce³⁺ (8%) (Versuchsnummer HU32/01) bei Anregung durch 400 nm. Das Maximum liegt bei 508 nm, die mittlere Wellenlänge bei 523 nm. Die Quanteneffizienz QE ist 45%. Die Reflexion (Figur 5b) beträgt bei 400 nm etwa R400 = 48% und bei 360 nm etwa R360 = 40 %.

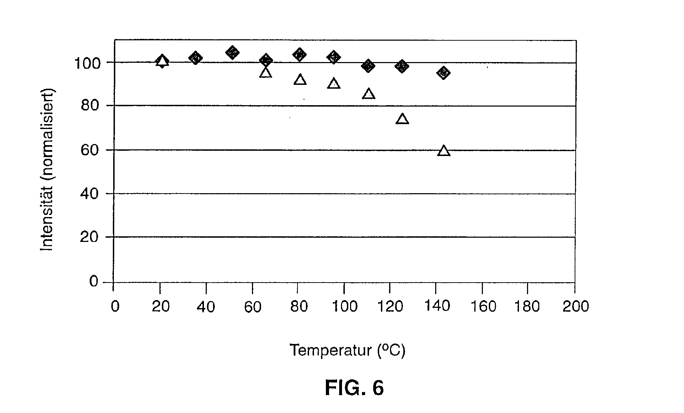

In Figur 6 ist die Quanteneffizienz als Funktion der Temperatur für verschiedene Leuchtstoffe dargestellt. Es zeigt sich, dass das grün emittierende an sich bekannte Thiogallat SrGa₂S₄:Eu (Kurve, die durch Dreiecke repräsentiert ist) zwar eine vergleichbare Quanteneffizienz (auf 100 % bei Raumtemperatur normalisiert) aufweist wie ein typisches Sialon (Kurve, die durch Rauten repräsentiert ist: hier HU18A/01 aus Tab. 1). Der Wert 100 % entspricht jeweils absolut einer Quanteneffizienz von etwa 66 %. Erstaunlicherweise verschlechtert sich die Quanteneffizienz des Thiogallats im Betrieb der LED unter typischen Temperaturbelastungen von 80°C bis 100 °C deutlich, während der Ce-dotierte Sialon-Leuchtstoff seineQuanteneffizienz fast konstant beibehält. Während also ein Ce-dotierter Sialon-Leuchtstoff auf den ersten Blick nur durchschnittliche Ergebnisse (bei Raumtemperatur) zu liefern scheint, ist seine Eignung für Lukoleds und andere temperaturbelastete Beleuchtungseinheiten sogar mit dem als Standard verwendeten YAG:Ce im Belastungsfall direkt vergleichbar.

Dies zeigt die besondere Eignung der Ce-dotierten Sialone für den Einsatz in Lumineszenzkonversions-LEDs und dabei insbesondere in Leuchtstoff-Mischungen zusammen mit anderen temperaturstabilen Leuchtstoffen wie beispielsweise SrS.

**Tab. 1**

| Verbindung | Kurzbezeichnung | QE | R360 | R400 | Max. Em. | x | y |
|---|---|---|---|---|---|---|---|
| Ca1.5Al3Si9N16:Ce3+ (2,7%) | HU18A/01 | 66 | 57 | 66 | 499 | 0,220 | 0,396 |
| Ca1.5Al3Si9N16:Ce3+ (5%) | HU31/01 | 53 | 48 | 55 | 498 | 0,237 | 0,422 |
| Ca1.5Al3Si9N16:Ce3+ (8%) | HU32/01 | 45 | 40 | 48 | 508 | 0,247 | 0,435 |
| Ca1.5Al3Si9N16:Ce3+ (2,7%) | HU18/01 | 61 | 55 | 67 | 497 | 0,225 | 0,397 |

## Patentansprüche

1. Beleuchtungseinheit mit mindestens einer LED als Lichtquelle, wobei die LED primäre Strahlung im Bereich 300 bis 430 nm, insbesondere 380 bis 420 nm, emittiert, wobei diese Strahlung vollständig in längerwellige Strahlung konvertiert wird durch Leuchtstoffe, die der primären Strahlung der LED ausgesetzt sind, **dadurch gekennzeichnet, dass** die Konversion zumindest unter Zuhilfenahme eines Leuchtstoffs erfolgt der grün mit einer Wellenlänge der Peakemission bei 495 bis 540 nm emittiert und der aus der Klasse der Ce-aktivierten Sialone stammt, wobei das Sialon der Formel M_{p/2}Si_{12-p-q}Al_{p+q}O_{q}N_{16-q}:Ce³⁺ gehorcht, mit M = Ca einzeln oder in Kombination mit Sr, mit q = 0 bis 2,5 und p = 1,5 bis 3.

2. Beleuchtungseinheit nach Anspruch 1, **dadurch gekennzeichnet, dass** das Ca teilweise (bis zu 30 mol-%) durch Sr ersetzt ist.

3. Beleuchtungseinheit nach Anspruch 1, **dadurch gekennzeichnet, dass** q < 1,insbesondere q ≤ 0,8, und/oder p = 2,5 bis 3 gewählt ist.

4. Beleuchtungseinheit nach Anspruch 1, **dadurch gekennzeichnet, dass** der mittlere Korndurchmesser des grünen Leuchtstoffs zwischen 0,5 und 5 µm beträgt.

5. Beleuchtungseinheit nach Anspruch 1, **dadurch gekennzeichnet, dass** zur Erzeugung von weißem Licht die primär emittierte Strahlung im Wellenlängenbereich 370 bis 420 nm liegt, wobei die primär emittierte Strahlung zumindest drei Leuchtstoffen mit Emissionsmaximum im Blauen (430 bis 470 nm), Grünen (495 bis 540 nm) und Roten (insbesondere 540 bis 620 nm) zur Konversion ausgesetzt ist.

6. Beleuchtungseinheit nach Anspruch 5, **dadurch gekennzeichnet, dass** der weitere rote Leuchtstoff ein Eu-dotiertes Sialon ist.

7. Beleuchtungseinheit nach Anspruch 1, **dadurch gekennzeichnet, dass** zur Erzeugung von farbigem Licht die primär emittierteStrahlung im UV-Wellenlängenbereich von 370 bis 420 nm liegt, wobei die primär emittierte Strahlung einem einzigen Leuchtstoff mit Emissionsmaximum im Grünen (495 nm bis 540 nm) entsprechend einem der vorherigen Ansprüche 1 bis 4 ausgesetzt ist.

8. Beleuchtungseinheit nach Anspruch 5, **dadurch gekennzeichnet, dass** der Mischungsanteil des grünen Leuchtstoffs etwa 0,5 bis 15 % beträgt.

9. Beleuchtungseinheit nach Anspruch 1, **dadurch gekennzeichnet, dass** als primäre Strahlungsquelle eine kurzwellig emittierende Leuchtdiode, insbesondere auf Basis von Ga(In)N, verwendet wird.

10. Beleuchtungseinheit nach Anspruch 1, **dadurch gekennzeichnet, dass** die Beleuchtungseinheit eine Lumineszenzkonversions-LED ist, bei der die Leuchtstoffe direkt oder mittelbar in Kontakt mit dem Chip stehen.

11. Beleuchtungseinheit nach Anspruch 1, **dadurch gekennzeichnet, dass** die Beleuchtungseinheit ein Feld (Array) von LEDs ist.

12. Beleuchtungseinheit nach Anspruch 12, **dadurch gekennzeichnet, dass** zumindest einer der Leuchtstoffe auf einer vor dem LED-Feld angebrachten optischen Vorrichtung angebracht ist.

13. Leuchtstoff aus der Klasse der Ce-dotierten Sialone, **dadurch gekennzeichnet, dass** das Ce-dotierte Sialon der Formel M_{p/2}Si_{12-p-q}Al_{p+q}O_{q}N_{16-q}:Ce³⁺ gehorcht, mit M = Ca einzeln oder in Kombination mit Sr, mit q = 0 bis 0,8 und p = 1,5 bis 3.
